# EUROPEAN PATENT APPLICATION

(11) **EP 2 511 946 A1**
(43) Date of publication of application: **17.10.2012**
(21) Application number: 10835989.4
(22) Date of filing: 08.12.2010
(51) Int. Cl.: H01L 21/205, C23C 16/44, C23C 16/503

(54) **METHOD FOR CLEANING FILM FORMING APPARATUS, FILM FORMING METHOD, AND FILM FORMING APPARATUS**

(30) Priority: 11.12.2009 JP 2009281328
(71) Applicant: Sharp Kabushiki Kaisha, Osaka-shi, Osaka 545-8522 (JP)
(72) Inventor: KISHIMOTO, Katsushi, Osaka 545-8522 (JP); ISSHIKI, Kazuhiko, Osaka 545-8522 (JP)
(74) Representative: Rocke, Carsten
(86) International application number: PCT/JP2010/071995
(87) International publication number: WO 2011/071069

(57) **Abstract**

Plasma is generated on the first condition between a cathode electrode (11) and an anode electrode (12). Then, plasma is generated on the second condition different from the first condition. The second condition is for spreading plasma between the cathode electrode (11) and the anode electrode (12) in the outer peripheral direction as compared with the first condition. Accordingly, in addition to a deposit on the electrode, a deposit on the member provided in the vicinity of the outer periphery of the electrode can be immediately removed.

## Description

### TECHNICAL FIELD

The present invention relates to a method of cleaning a film forming apparatus, a film forming method and a film forming apparatus, and particularly to a method of cleaning a film forming apparatus for forming a film using plasma, a film forming method and a film forming apparatus.

### BACKGROUND ART

A silicon-based thin film may be formed by the method of manufacturing a semiconductor device such as a liquid crystal display device and a thin-film solar cell. This film formation is performed, for example, by a plasma CVD (Chemical Vapor Deposition) apparatus. As this film formation is repeated, a silicon-based deposit is accumulated within the film forming chamber of the film forming apparatus. Since the accumulated deposit leads to an increase in particles within the film forming chamber, this deposit needs to be removed periodically. In other words, the film forming apparatus needs to be cleaned periodically.

According to Japanese Patent Laying-Open No. 06-318580 (PTL 1), plasma used for the above-described cleaning is generated using the mixed gas of NF₃ gas and Ar gas.

### CITATION LIST

### PATENT LITERATURE

PTL 1: Japanese Patent Laying-Open No. 06-318580

### SUMMARY OF INVENTION

### TECHNICAL PROBLEM

The above-described deposit adheres not only onto the electrode for generating plasma, but also onto the member provided in the vicinity of the outer periphery of the electrode. Examples of such a member may include a wiring line for controlling an electrode potential, a wiring line for supplying electric power to the heater incorporated in the electrode, and a pipe for supplying process gas to the electrode.

Although the above-described conventional cleaning method allows the deposit on the electrode to be relatively immediately removed, it causes a problem that it takes a long period of time to remove the deposit on the member provided in the vicinity of the outer periphery of the electrode.

Accordingly, an object of the present invention is to provide a method of cleaning a film forming apparatus that allows immediate removal not only of the deposit on the electrode but also of the deposit on the member disposed in the vicinity of the outer periphery of the electrode; a film forming method utilizing this cleaning method; and a film forming apparatus suitable for performing this cleaning method.

### SOLUTION TO PROBLEM

A method of cleaning a film forming apparatus according to the present invention provides a method of cleaning a film forming apparatus whereby removing a silicon-based deposit adhering within a film forming chamber included in the film forming apparatus for forming a silicon-based thin film using plasma generated by applying an alternating-current (AC) voltage between a first pair of electrodes. The method includes the following steps.

Plasma is generated between the first pair of electrodes on a first condition. Then, plasma is generated on a second condition different from the first condition. The second condition is for spreading the plasma between the first pair of electrodes in an outer peripheral direction as compared with the first condition.

According to the method of cleaning a film forming apparatus according to the present invention, after the deposits on the first pair of electrodes are first removed by the plasma generated on the first condition, the condition for generating plasma is switched to the second condition, so that the plasma is spread in the outer peripheral direction of the first pair of electrodes. Consequently, the deposit on the member disposed in the vicinity of the outer periphery of the electrode is immediately removed.

Preferably, the above-described cleaning method further includes the step of detecting a change in a plasma state between the first pair of electrodes. In accordance with the change in the plasma state, the step of generating plasma on the first condition is switched to the step of generating plasma on the second condition.

Preferably, the step of detecting the change in the plasma state includes the step of detecting an absolute value of a self bias between the first pair of electrodes. In accordance with a decrease in the absolute value of the self bias, the step of generating plasma on the first condition is switched to the step of generating plasma on the second condition.

Preferably, the step of detecting the change in the plasma state includes the step of detecting a circuit constant of an impedance matching circuit connected to the first pair of electrodes. In accordance with a change in the circuit constant, the step of generating plasma on the first condition is switched to the step of generating plasma on the second condition.

Preferably, the step of detecting the change in the plasma state includes the step of detecting intensity of light from an outer periphery between the first pair of electrodes. In accordance with a decrease in the intensity of the light, the step of generating plasma on the first condition is switched to the step of generating plasma on the second condition.

Preferably, in the above-described cleaning method, a second pair of electrodes is provided within the film forming chamber.

A film forming method according to the present invention includes the steps of removing the silicon-based deposit by the above-described method of cleaning a film forming apparatus, and, after this step of removal, forming the silicon-based thin film using the film forming apparatus.

A film forming apparatus according to the present invention is for forming a silicon-based thin film and includes a film forming chamber; a power supply generating an AC voltage; a first pair of electrodes; and a detection unit. The first pair of electrodes is provided within the film forming chamber and connected to the power supply. The first pair of electrodes is for generating plasma between the first pair of electrodes. The detection unit detects a change in a plasma state between the first pair of electrodes.

### ADVANTAGEOUS EFFECTS OF INVENTION

As described above, according to the present invention, the deposit on the member disposed in the vicinity of the outer periphery of the electrode is immediately removed.

### BRIEF DESCRIPTION OF DRAWINGS

Fig. 1 is a cross sectional view schematically showing the configuration of a film forming apparatus in the first embodiment of the present invention.
Fig. 2 is a circuit diagram schematically showing an impedance matching circuit in Fig. 1.
Fig. 3 is a cross sectional view schematically showing the manner of the film forming method using the film forming apparatus in Fig. 1.
Fig. 4 is a diagram schematically showing the relationship between the mixing ratio of process gas introduced into the film forming apparatus in Fig. 1 and the plasma distribution.
Fig. 5 is a cross sectional view schematically showing the plasma distribution in a flow rate region R1 in Fig. 4.
Fig. 6 is a cross sectional view schematically showing the plasma distribution in a flow rate region R2 in Fig. 4.
Fig. 7 is a cross sectional view schematically showing the plasma distribution in the vicinity of a dashed line La in a flow rate region R3 in Fig. 4.
Fig. 8 is a cross sectional view schematically showing the plasma distribution in the vicinity of a dashed line Lb in a flow rate region R3 in Fig. 4.
Fig. 9 is a cross sectional view schematically showing the plasma distribution in the vicinity of a dashed line Lc in a flow rate region R3 in Fig. 4.
Fig. 10 is a cross sectional view schematically showing the plasma distribution in a flow rate region R4 in Fig. 4.
Fig. 11 is a graph chart schematically showing a temporal change in the absolute value of the self bias between the first electrodes in accordance with the cleaning method in the first embodiment of the present invention.
Fig. 12 is a graph chart schematically showing a temporal change in the circuit constant of an impedance matching circuit in Fig. 2 in accordance with the cleaning method in the first embodiment of the present invention.
Fig. 13 is a graph chart schematically showing a temporal change in the intensity of light from the outer periphery of the first pair of electrodes in accordance with the cleaning method in the first embodiment of the present invention.
Fig. 14 is a cross sectional view schematically showing the configuration of a film forming apparatus in the second embodiment of the present invention.

### DESCRIPTION OF EMBODIMENTS

The embodiments of the present invention will be hereinafter described with reference to the accompanying drawings.

### (First Embodiment)

The film forming apparatus of the present embodiment will be first described below.

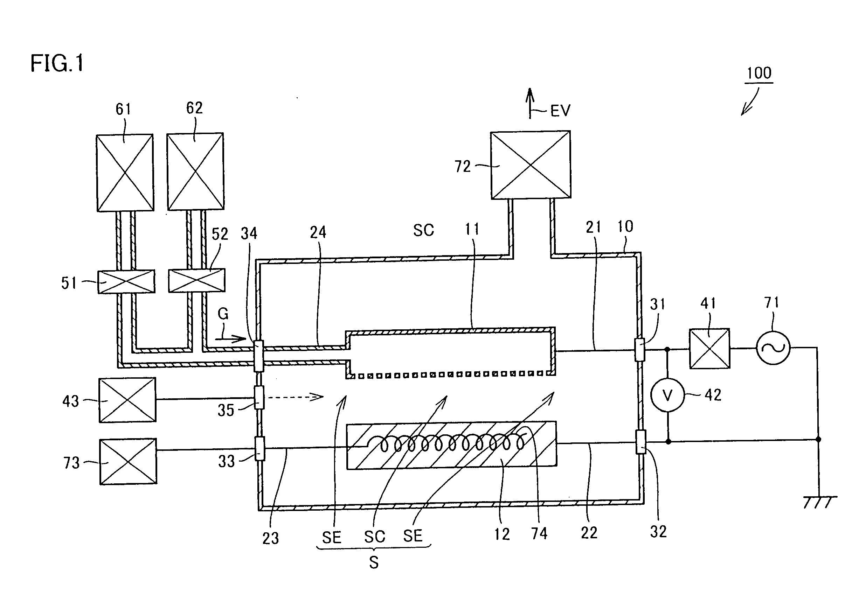

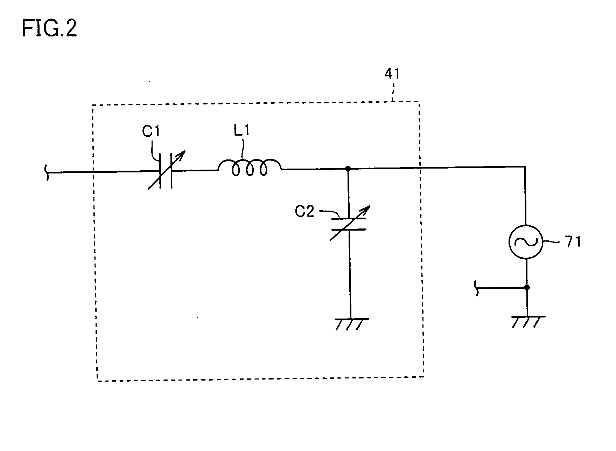

Referring to Figs. 1 and 2, a film forming apparatus 100 of the present embodiment includes a film forming chamber 10, a cathode electrode 11, an anode electrode 12, wiring lines 21 to 23, a gas pipe 24, feedthroughs 31 to 35, an impedance matching circuit 41, a voltmeter 42, an emission spectrometer 43, flow rate controllers 51 and 52, an NF₃ gas cylinder 61, an Ar gas cylinder 62, an RF (Radio Frequency) power supply 71 (AC power supply), a vacuum pump 72, a heater power supply 73, and a heater element 74.

Film forming chamber 10 is a vacuum chamber for performing a film forming process.

Cathode electrode 11 and anode electrode 12 are disposed to face each other, thereby forming a pair of electrodes (first pair of electrodes). In the figure, a region S between cathode electrode 11 and anode electrode 12 includes the center portion represented as a center region SC and an outer portion represented as an outer region SE.

Cathode electrode 11 is connected to RF power supply 71 sequentially through wiring line 21, feedthrough 31 and impedance matching circuit 41. Cathode electrode 11 also has a hole through which process gas is supplied toward region S between cathode electrode 11 and anode electrode 12.

Anode electrode 12 is grounded sequentially through wiring line 22 and feedthrough 32. Furthermore, heater element 74 is disposed within anode electrode 12. Heater element 74 is connected to heater power supply 73 sequentially through wiring line 23 and feedthrough 33.

NF₃ gas cylinder 61 and Ar gas cylinder 62 are connected such that the mixed gas of NF₃ gas and Ar gas having the mixing ratio controlled by flow rate controllers 51 and 52, respectively, can be supplied as shown by an arrow G in the figure. Furthermore, feedthrough 34 and gas pipe 24 are connected so as to supply this mixed gas to cathode electrode 11.

Vacuum pump 72 is connected such that the gas within film forming chamber 10 can be exhausted as shown by an arrow EV in the figure. Accordingly, the pressure within film forming chamber 10 can be adjusted.

Voltmeter 42 has one end connected between cathode electrode 11 and impedance matching circuit 41, and also has the other end grounded. This allows detection of the absolute value of the self bias between cathode electrode 11 and anode electrode 12.

Impedance matching circuit 41 includes capacitances C1 and C2 and an inductance L1, as shown in Fig. 2. By optimizing capacitances C1 and C2, the impedance of the plasma generated between cathode electrode 11 and anode electrode 12 is matched to the impedance of RF power supply 71.

As shown by a dashed arrow in the figure, emission spectrometer 43 can measure, through feedthrough 35, the intensity of the light from outer region SE.

Then, the film forming method according to the present embodiment will be hereinafter described.

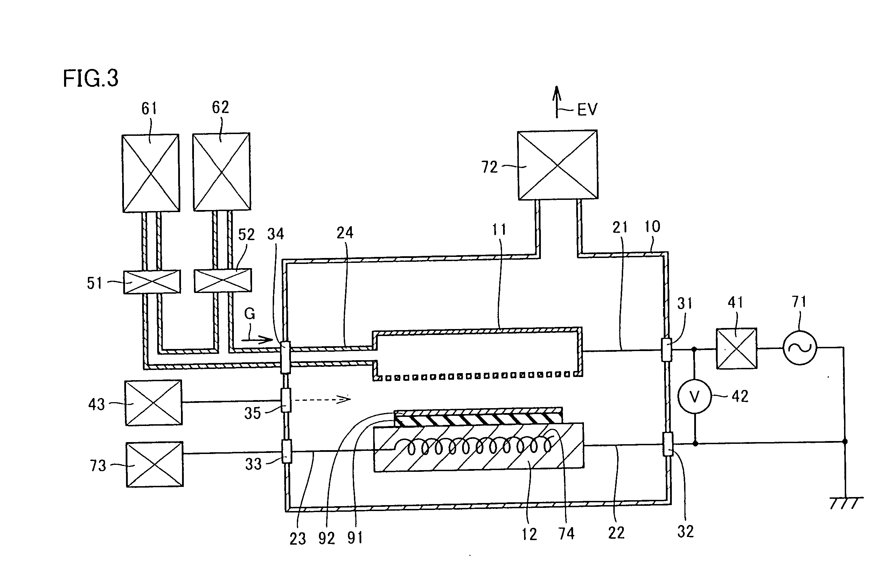

Referring to Fig. 3, a substrate 91 is placed on anode electrode 12. Then, the process gas for forming a silicon-based thin film 92 is introduced through a gas system (not shown) therefor into film forming chamber 10. This process gas is, for example, mixed gas of silane gas and hydrogen gas.

Then, an AC voltage is supplied between cathode electrode 11 and anode electrode 12 from RF power supply 71 through impedance matching circuit 41. This leads to generation of plasma between cathode electrode 11 and anode electrode 12, thereby forming silicon-based thin film 92 by the plasma CVD.

As the above-described film formation is repeated, a silicon-based deposit becomes accumulated within film forming chamber 10. This deposit adheres not only onto cathode electrode 11 and anode electrode 12, but also onto wiring lines 21 to 23 and gas pipe 24 which are provided in the vicinity of the outer periphery of each electrode.

Then, cleaning described later is performed in order to remove the above-described deposit. After the deposit is removed by this cleaning, film formation is resumed. Thus, it becomes possible to perform film formation under the circumstances in which particles are few.

Then, the relationship between the mixing ratio of the mixed gas used in this cleaning method and the plasma distribution will be hereinafter described. In the present cleaning method, the mixed gas of Ar gas and NF₃ gas as the above-described mixed gas is introduced as shown by an arrow G (Fig. 1) to generate plasma for performing cleaning.

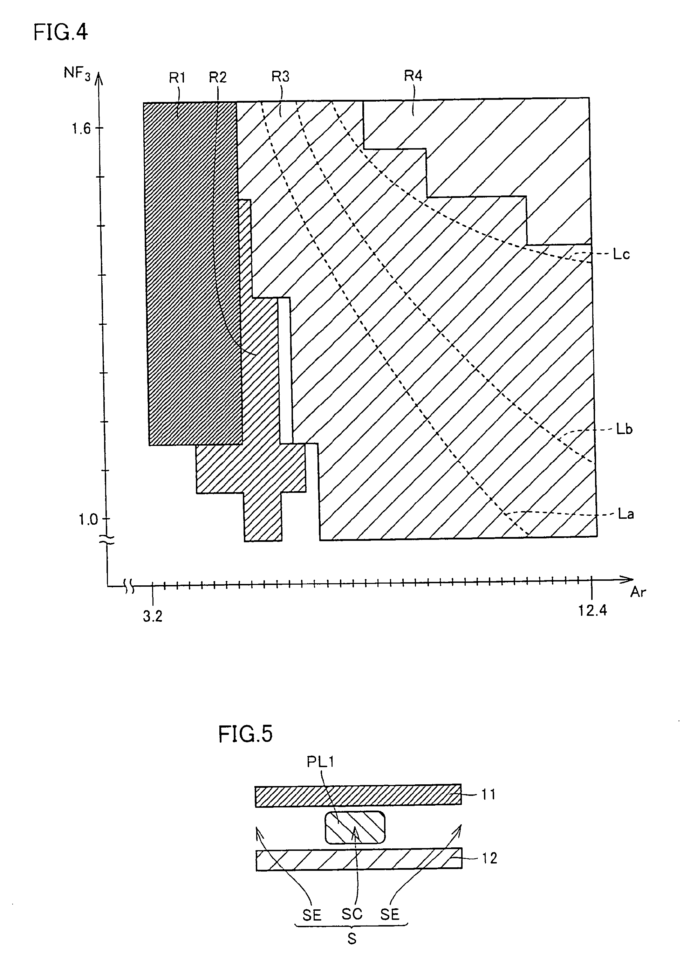

Referring to Fig. 4, the distribution of this plasma may change depending on the flow rate conditions of Ar gas and NF₃ gas. In the figure, the vertical axis and the horizontal axis show the flow rates of NF₃ gas and Ar gas, respectively, using arbitrary unit in common between the vertical axis and the horizontal axis.

Referring to Fig. 5, when the flow rate condition is in a flow rate region R1 (Fig. 4), plasma presents distribution PL1. Distribution PL1 becomes concentrated in center region SC, which tends to cause damage to the electrode. Therefore, it is preferable to avoid use of distribution PL1.

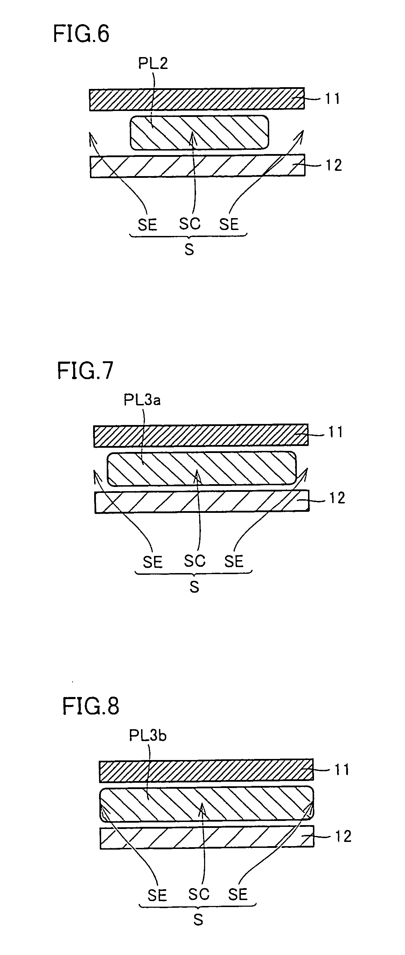

Referring to Fig. 6, when the flow rate condition is in a flow rate region R2 (Fig. 4), plasma presents distribution PL2. Distribution PL2 becomes concentrated in center region SC to some extent.

Referring to Fig. 7, when the flow rate condition is in the vicinity of a dashed line La in a flow rate region R3 (Fig. 4), plasma presents distribution PL3a. Although distribution PL3a spreads in almost entire region S, the plasma is relatively weakly discharged in outer region SE.

Referring to Fig. 8, when the flow rate condition is in the vicinity of a dashed line Lb in flow rate region R3 (Fig. 4), plasma presents distribution PL3b. Distribution PL3b spreads in entire region S.

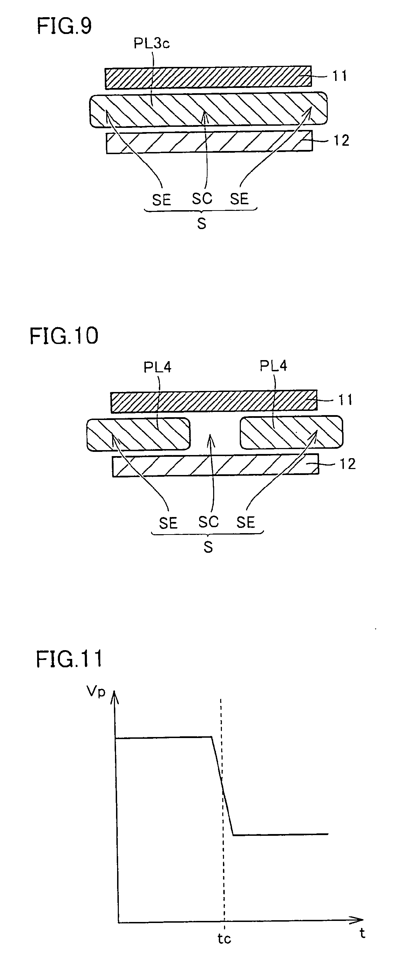

Referring to Fig. 9, when the flow rate condition is in the vicinity of a dashed line Lc in flow rate region R3 (Fig. 4), plasma presents distribution PL3c. Although distribution PL3c spreads in almost entire region S, the plasma is relatively strongly discharged in outer region SE.

Referring to Fig. 10, when the flow rate condition is in a flow rate region R4 (Fig. 4), plasma presents distribution PL4. Distribution PL4 becomes concentrated in outer region SE, which tends to cause abnormal discharge to occur. Therefore, it is preferable to avoid use of distribution PL4.

Then, a specific cleaning method according to the present embodiment will be hereinafter described.

First, plasma is generated between cathode electrode 11 and anode electrode 12 on the flow rate condition (the first condition) shown by dashed line La or Lb in flow rate region R3 (Fig. 4). In other words, plasma presenting distribution PL3a or PL3b is generated. When this plasma is maintained for a certain period of time, deposits on cathode electrode 11 and anode electrode 12 are removed. However, due to low intensity of the plasma in outer region SE, the deposit on the member located in the vicinity of outer region SE, that is, wiring lines 21 to 23 and gas pipe 24, is scarcely removed at this point of time.

When the deposits on cathode electrode 11 and anode electrode 12 are removed as described above, the plasma state changes. This change can be detected by any one of the first to third detection methods as described below.

Referring to Fig. 11, first, an absolute value Vp of the self bias between cathode electrode 11 and anode electrode 12 is decreased at a point of time tc at which the deposits on cathode electrode 11 and anode electrode 12 are removed. This change can be detected by voltmeter (first detection unit) 42 (Fig. 1) (the first detection method).

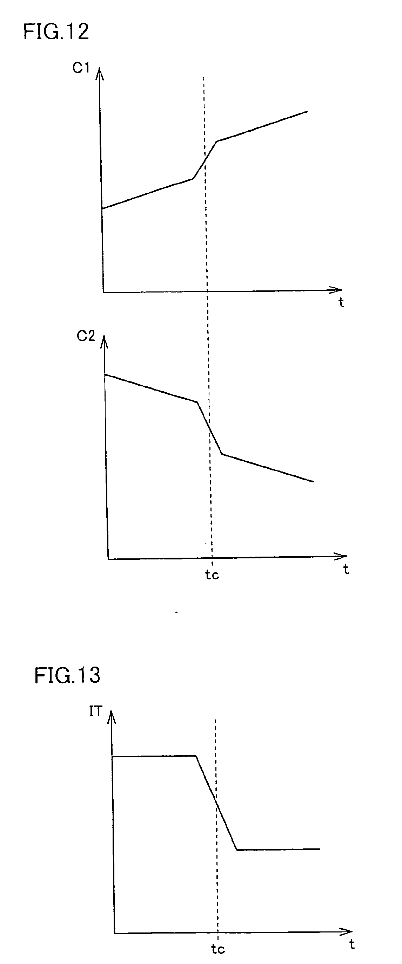

Referring to Fig. 12, secondly, the circuit constant of impedance matching circuit (the second detection unit) 41 changes. In other words, capacitances C1 and C2 change. Therefore, this change can be detected by monitoring the circuit constant (the second detection method).

Referring to Fig. 13, thirdly, the intensity of the plasma in outer region SE is decreased, to cause a change to occur such that the plasma distribution is reduced to center region SC. This change can be detected by emission spectrometer (the third detection unit) 43 (Fig. 1) (the third detection method).

In the present embodiment, the flow rate condition is switched to the condition (the second condition) located in the vicinity of dashed line Lc (Fig. 4) in response to detection performed in accordance with at least any one of the above-described first to third detection methods. In other words, plasma is spread in the outer peripheral direction in region S. Consequently, plasma presenting distribution PL3c is generated. When this plasma is maintained for a certain period of time, the intensity of the plasma in outer region SE is increased, so that the deposit on the member located in the vicinity of outer region SE, that is, wiring lines 21 to 23 and gas pipe 24, is efficiently removed.

In this way, the cleaning method according to the present embodiment is carried out.

According to the cleaning method of the present embodiment, first, the deposits on cathode electrode 11 and anode electrode 12 (Fig. 1) are removed immediately by the plasma generated on the flow rate condition in the vicinity of dashed line La or Lb (Fig. 4) and presenting distribution PL3a (Fig. 7) or PL3b (Fig. 8).

Then, the flow rate condition is switched to the flow rate condition in the vicinity of dashed line Lc (Fig. 4), thereby causing the plasma to be spread in the outer peripheral direction in region S. Consequently, the deposit on the member disposed in the vicinity of outer region SE, that is, wiring lines 21 to 23 and gas pipe 24, is immediately removed.

### (Second Embodiment)

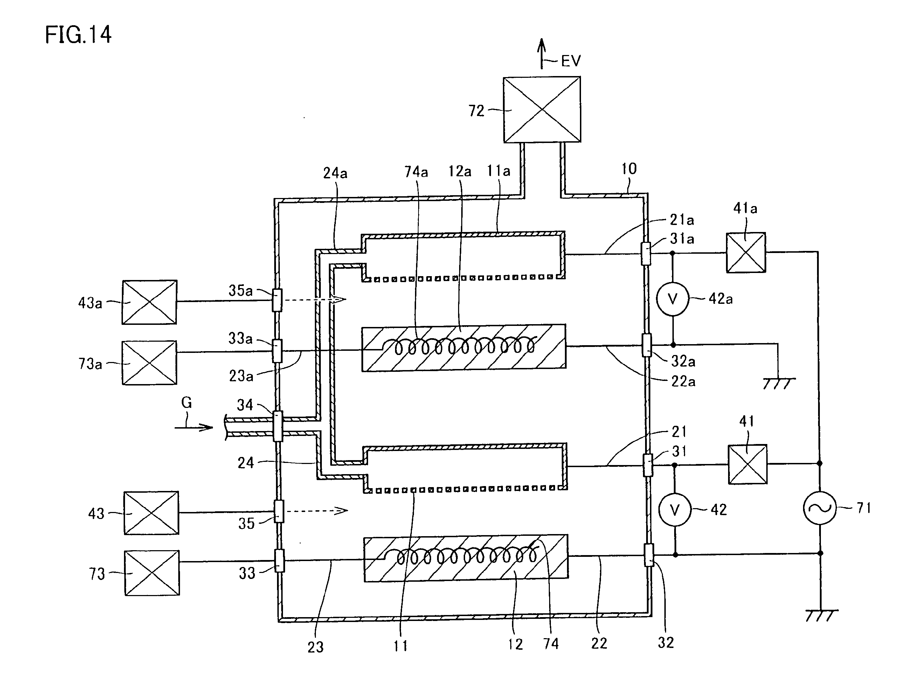

Referring to Fig. 14, in contrast to film forming apparatus 100 (Fig. 1: first embodiment), the film forming apparatus according to the present embodiment can form a film simultaneously on each of a plurality of substrates. For this purpose, a pair of electrodes (second pair of electrodes) including a cathode electrode 11a and an anode electrode 12a is further provided. Furthermore, in order to use this second pair of electrodes in the same manner as that of the first pair of electrodes (Fig. 1: cathode electrode 11 and anode electrode 12) in the first embodiment, in addition to the configuration of film forming apparatus 100, the film forming apparatus includes wiring lines 21a to 23a, a gas pipe 24a, feedthroughs 31a, 32a, 33a, and 35a, an impedance matching circuit 41a, a voltmeter 42a, an emission spectrometer 43a, a heater power supply 73a, and a heater element 74a.

The present embodiment can also achieve effects similar to those in the first embodiment even when the film forming apparatus forming a film simultaneously on each of a plurality of substrates is used.

Furthermore, in the case where the point of time corresponding to point of time tc (Figs. 11 to 13) is detected also for the second pair of electrodes, the deposit on the member located in the vicinity of the outer periphery of each of the first and second pairs of electrodes can be more reliably and efficiently removed.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

The present invention can be particularly advantageously applied to a method of cleaning a film forming apparatus for forming a film using plasma, and a film forming method.

### REFERENCE SIGNS LIST

10 film forming chamber, 11, 11a cathode electrode, 12, 12a anode electrode, 21 to 23, 21a to 23a wiring line, 24, 24a gas pipe, 31 to 35, 31a to 33a, 35a feedthrough, 41, 41a impedance matching circuit, 42, 42a voltmeter, 43, 43a emission spectrometer, 51, 52 flow rate controller, 61 NF₃ gas cylinder, 62 Ar gas cylinder, 71 RF power supply (AC power supply), 72 vacuum pump, 73, 73a heater power supply, 74, 74a heater element, 100 film forming apparatus.

## Claims

1. A method of cleaning a film forming apparatus (100) whereby removing a silicon-based deposit adhering within a film forming chamber (10) included in the film forming apparatus for forming a silicon-based thin film (92) using plasma generated by applying an alternating-current (AC) voltage between a first pair of electrodes (11, 12), said method comprising the steps of:
generating plasma between said first pair of electrodes on a first condition; and
after said step of generating plasma on said first condition, generating plasma on a second condition different from said first condition,
said second condition being for spreading the plasma between said first pair of electrodes in an outer peripheral direction as compared with said first condition.

2. The method of cleaning a film forming apparatus according to claim 1, further comprising the step of detecting a change in a plasma state between said first pair of electrodes, wherein
in accordance with the change in said plasma state, said step of generating plasma on said first condition is switched to said step of generating plasma on said second condition.

3. The method of cleaning a film forming apparatus according to claim 2,
wherein
said step of detecting the change in said plasma state includes the step of detecting an absolute value of a self bias between said first pair of electrodes, and
in accordance with a decrease in the absolute value of said self bias, said step of generating plasma on said first condition is switched to said step of generating plasma on said second condition.

4. The method of cleaning a film forming apparatus according to claim 2,
wherein
said step of detecting the change in said plasma state includes the step of detecting a circuit constant of an impedance matching circuit (41) connected to said first pair of electrodes, and
in accordance with a change in said circuit constant, said step of generating plasma on said first condition is switched to said step of generating plasma on said second condition.

5. The method of cleaning a film forming apparatus according to claim 2,
wherein
said step of detecting the change in said plasma state includes the step of detecting intensity of light from an outer periphery between said first pair of electrodes, and
in accordance with a decrease in said intensity of light, said step of generating plasma on said first condition is switched to said step of generating plasma on said second condition.

6. The method of cleaning a film forming apparatus according to any one of claims 1 to 5, wherein a second pair of electrodes (11a, 12a) is provided within said film forming chamber.

7. A film forming method comprising the steps of:
removing said silicon-based deposit by the method of cleaning a film forming apparatus (100) according to any one of claims 1 to 6; and
after said step of removing said silicon-based deposit, forming said silicon-based thin film using said film forming apparatus.

8. A film forming apparatus (100) for forming a silicon-based thin film, said film forming apparatus comprising:
a film forming chamber (10);
a power supply (71) generating an AC voltage;
a first pair of electrodes (11, 12) provided within said film forming chamber and connected to said power supply, said first pair of electrodes being for generating plasma between said first pair of electrodes; and
a detection unit (41 to 43) detecting a change in a plasma state between said first pair of electrodes.
